# EUROPÄISCHE PATENTSCHRIFT

(11) **EP 0 447 942 B1**
(45) Veröffentlichungstag und Bekanntmachung des Hinweises auf die Patenterteilung: **14.09.1994**
(21) Anmeldenummer: 91103859.4
(22) Anmeldetag: 13.03.1991
(51) Int. Cl.: H05K 9/00

(54) **Kontaktleiste für eine störstrahlungsdichte Verbindung benachbarter metallischer Wandelemente**
EMI impermeable multiple plug for interconnection of metallic board elements
Réglette enfichable pour une interconnexion imperméable à des rayonnements perturbateurs d'éléments de bord voisins métalliques

(30) Priorität: 19.03.1990 DE 9003209 U
(43) Veröffentlichungstag der Anmeldung: 25.09.1991
(73) Patentinhaber: Siemens Nixdorf Informationssysteme Aktiengesellschaft, 33102 Paderborn (DE)
(72) Erfinder: Knoop, Franz, W-4793 Büren-Steinhausen (DE); Werner, Franz, W-4790 Paderborn (DE)
(74) Vertreter: Fuchs, Franz-Josef, Dr.-Ing.

(56) Entgegenhaltungen:
- DD-A- 2 002 527
- DE-A- 2 750 088
- DE-A- 3 039 681
- GB-A- 2 183 920
- US-A- 4 780 570

## Beschreibung

Die Erfindung betrifft eine Kontaktleiste der im Oberbegriff des Anspruches 1 genannten Art.

Es ist eine gängige Technik, Schaltungsplatinen an einer Kante mit einem quer zur Platinenebene stehenden Wandelement zu versehen, wobei sich die Wandelemente mehrerer nebeneinander in ein Gehäuse eingeschobener Schaltungsplatinen zu einer mehr oder weniger geschlossenen Abschlußwand ergänzen. Die Wandelemente sind entweder geschlossene Flächen oder sie sind mit Steckerelementen versehen, über die die jeweiligen Schaltungsplatinen mit äußeren Geräten elektrisch verbunden werden können. Damit die aus den Wandelementen gebildete Wand gegen elektromagnetische Störstrahlung dicht ist, müssen die einzelnen Wandelemente elektrisch leitend miteinander verbunden werden.

Es ist bereits bekannt, an den Längskanten der Wandelemente jeweils über diese Längskanten überstehende federnde Kontaktbleche anzuordnen, die mit Kontaktblechen benachbarter Wandelemente in Berührung kommen. Bei dieser Konstruktion ist an jeder einem benachbarten Wandelement zugewandten Seitenkante eines Wandelementes ein Kontaktblech befestigt, was diese Lösung aufwendig und teuer macht.

Es ist auch bereits durch die DD-C- 200 252 bekannt, jeweils an einem im wesentlichen rechtwinklig abgekanteten Randsteg eines Wandelementes eine Kontaktleiste gemäß dem Oberbegriff des Anspruches 1 mit vorstehenden Kontaktvorsprüngen zu befestigen, die sich gegen eine am benachbarten Wandelement ausgebildete Kontaktfläche anlegen. Die Kontaktleiste weist über ihre ganze Länge lückenlos aufeinanderfolgende, durch Prägungen hergestellte Kontaktausbeulungen auf. Dadurch wird die Kontaktleiste einerseits äußerst steif, so daß sie sich z.B. unvermeidlichen Verformungen des zugeordneten Wandelementes infolge Fertigungsungenauigkeiten nicht mehr anpassen kann, wodurch das Aufstecken der Kontaktleiste unter Umständen sehr erschwert wird. Außerdem ist die Zahl der Kontaktstellen zum benachbarten Wandelement sehr hoch, so daß z.B. ein Einschieben der Kontaktleiste zwischen zwei benachbarte Wandelemente häufig nur mit Schwierigkeiten möglich ist. Ein weiterer Nachteil wird darin gesehen, daß die Kontaktleiste über ihre gesamte Länge klammerartig umgebogen ist. Auch dieses Merkmal führt dazu, daß die Kontaktleiste sehr steif wird, so daß sich die beschriebenen Schwierigkeiten noch verstärken. Auch die Klammereinrichtung selbst erfordert wegen der großen Klammerfläche schon bei geringen Überdicken des Wandelementes bzw. z.B. bei Rostansatz große Kräfte beim Aufstecken auf das Wandelement.

Es ist die Aufgabe der vorliegenden Erfindung, ein Kontaktleiste der im Oberbegriff des Anspruches 1 genannten Art zu schaffen, welches herstellungstechnisch und montagetechnisch sehr einfach und damit preiswert ist und welches auch bei fertigungsbedingten oder z.B. durch Rostansatz oder dergleichen verursachten Ungenauigkeiten der Wandelemente keine übermäßigen Kräfte bei der Montage erfordert.

Diese Aufgabe ist erfindungsgemäß durch die im Anspruch 1 enthaltenen Merkmale gelöst.

Die Erfindung macht sich zunächst die Erkenntnis zunutze, daß eine störstrahlsichere Abschirmung keinen lückenlosen Kontakt bzw. eine sehr dichte Anordnung der Kontaktbereiche erfordert. Vielmehr sind größere Lükken, deren Größe sich nach der Art der abzuschirmenden Elektrostörstrahlung richtet, zwischen den Kontaktbereichen unschädlich.

Durch die erfindungsgemäße Ausgestaltung und Anordnung der Kontaktzungen ergibt sich im Gegensatz zu der bekannten geprägten Ausführung eine sehr flexible Kontaktleiste, die sich leicht an Verformungen des Wandelementes anpaßt, ohne daß die Störstrahlabschirmung merklich verschlechtert wird. Durch die erfindungsgemäße Ausgestaltung und Anordnung der Klammerelemente ergibt sich auch in diesem Bereich keine zu große Steifigkeit. Außerdem sind auch die durch die Kontaktzungen einerseits und die Klammerelemente andererseits verursachten Reibungskräfte gegenüber der bekannten Lösung weniger von Fertigungsungenauigkeiten bzw. vom Oberflächenzustand der Wandelemente abhängig.

Die Kontaktzungen können in einfacher Weise durch einen einzigen Stanz-Biegevorgang hergestellt werden.

Die Klammerelemente sind vorzugsweise mit der Kontaktleiste einstückig ausgebildet; sie können ebenfalls durch einen einzigen Stanz-Biegevorgang hergestellt werden, und zwar bei geeignetem Werkzeug in einem Arbeitsgang mit der Herstellung der Kontaktzungen.

Die geeigneten Abstände der Kontaktzungen lassen sich in bekannter Weise aus den Eigenschaften der gegebenen, abzuschirmenden Störstrahlung ermitteln.

Um einen guten Halt der Kontaktleiste auf dem Randsteg sicherzustellen, ist weiterhin erfindungsgemäß vorgesehen, daß die Klammerelemente jeweils mit Rastausnehmungen zum Verrasten mit am Randsteg ausgebildeten Rastvorsprüngen versehen sind. Die Rastausnehmungen rasten beim Aufstecken der Kontaktleiste auf den Randsteg selbsttätig ein und stellen einerseits eine genaue Ausrichtung der Kontaktleiste auf dem Randsteg und andererseits einen festen Halt der Kontaktleiste sicher.

Die Kontaktzungen haben vorzugsweise im Längsschnitt etwa die Form eines stumpfwinkligen Hakens mit einem ersten, aus der Kontaktleistenebene herausgebogenen Schenkel und einem anschließenden, in Richtung zur Kontaktleistenebene zurückgebogenen Schenkel. Die Biegekante zwischen dem ersten Schenkel und dem zweiten Schenkel bildet eine linienförmige, an der Kontaktfläche des benachbarten Wandelementes anliegende Kontaktzone.

Außerdem ist erfindungsgemäß vorgesehen, daß der den Klammerelementen abgewandte Längsrand der Kontaktleiste zur Seite der Klammerelemente hin abgekantet ist. Diese Ausbildung stellt sicher, daß sich dieser Längsrand beim Einschieben einer Schaltungsplatine und damit bei einem Positionieren eines Wandelementes zwischen bereits vorhandene Wandelemente nicht mit dem zugeordneten, benachbarten Wandelement verhakt.

Die Kontaktzungen sind gemäß einer weiteren Ausgestaltung der Erfindung jeweils mit einer den Materialquerschnitt im Ausbiegekantenbereich verringernden Aussparung versehen. Durch eine geeignete Wahl der Abmessungen dieser Aussparung kann der verbleibende Materialquerschnitt und damit die Federkraft der Kontaktzungen bestimmt werden.

Weitere Merkmale sowie Vorteile der Erfindung ergeben sich aus den Ansprüchen sowie aus der Beispielsbeschreibung. Ein Ausführungsbeispiel ist in der Zeichnung dargestellt und im folgenden näher beschrieben. Es zeigen:
- Fig. 1: in perspektivischer Darstellung einen Teil eines Wandelementes mit aufgeklemmter Kontaktleiste;
- Fig. 2: einen Querschnitt durch ein zwischen einem benachbarten Wandelement und einer Gerätewand angeordneten Wandelement, mit montierten Kontaktleisten;
- Fig. 3: in vergrößerter Darstellung einen Querschnitt durch eine Kontaktleiste;
- Fig. 4: eine Ansicht einer Kontaktleiste von der Vorderseite her;
- Fig. 5: eine Ansicht einer Kontaktleiste gemäß Fig. 4 von der Rückseite her.

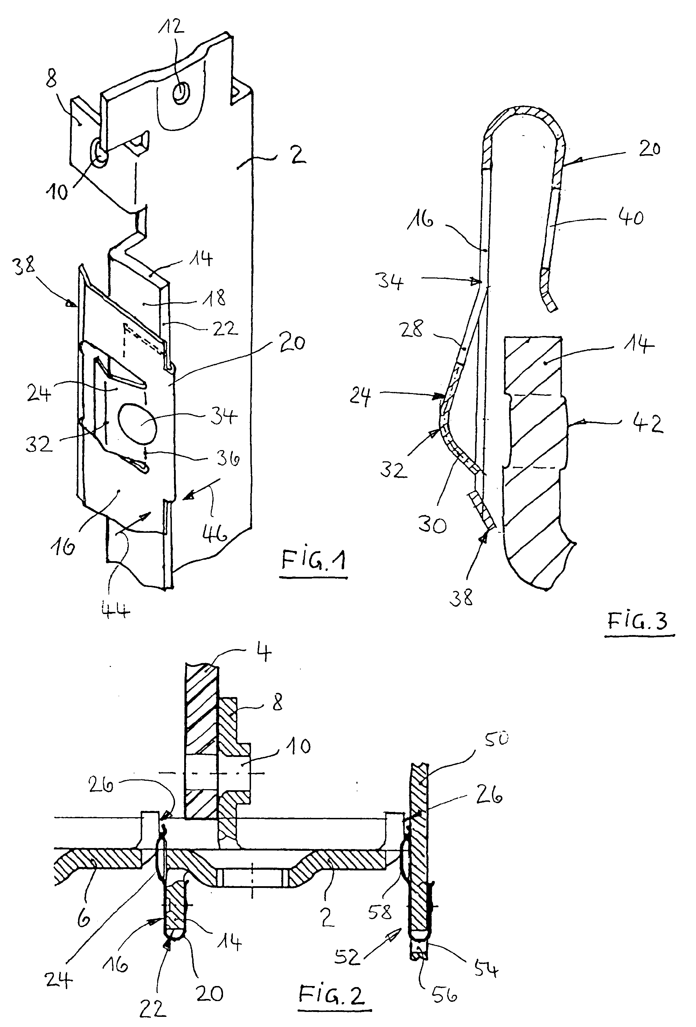

Fig. 1 zeigt in perspektivischer Darstellung, Fig. 2 in einem Querschnitt ein Wandelement 2, welches dazu bestimmt ist, an einer Kante einer Schaltungsplatine 4 befestigt zu werden, wie insbesondere Fig. 2 erkennen läßt. Mehrere nebeneinander angeordnete Wandelemente 2, 6, die mit einem Gerätechassis verschraubt werden können, bilden eine mehr oder weniger geschlossene Gerätewand, die den Aufnahmeraum für die eingeschobenen Schaltungsplatinen 4 nach außen abschließt. Zur Befestigung der Schaltungsplatine 4 am Wandelement 2 ist eine Befestigungslasche 8 mit einer daran ausgebildeten Gewindebohrung 10 vorgesehen, so daß die Schaltungsplatine 4 mit der Befestigungslasche 8 verschraubt werden kann. Eine am oberen Ende des Wandelementes 2 ausgebildete Bohrung 12 dient in nicht näher dargestellter Weise zum Befestigen des Wandelementes an einem Gerätechassis.

Am Wandelement 2 ist ein im wesentlichen rechtwinklig zur Wandelementebene abgekanteter Randsteg 14 ausgebildet, auf die eine Kontaktleiste 16 aufgeklemmt werden kann. Die Kontaktleiste 16 liegt auf der dem benachbarten Wandelement 6 zugewandten Außenseite 18 des Randsteges 14 auf. Sie ist mit Klammerelementen 20 versehen, die die freie Kante 22 des Randsteges übergreifen und die Kontaktleiste 16 auf dem Randsteg 14 festhalten. Die Klammerelemente 20 sind mit der Kontaktleiste 16 einstückig ausgebildet und beispielsweise durch einen Stanz-Biegevorgang hergestellt.

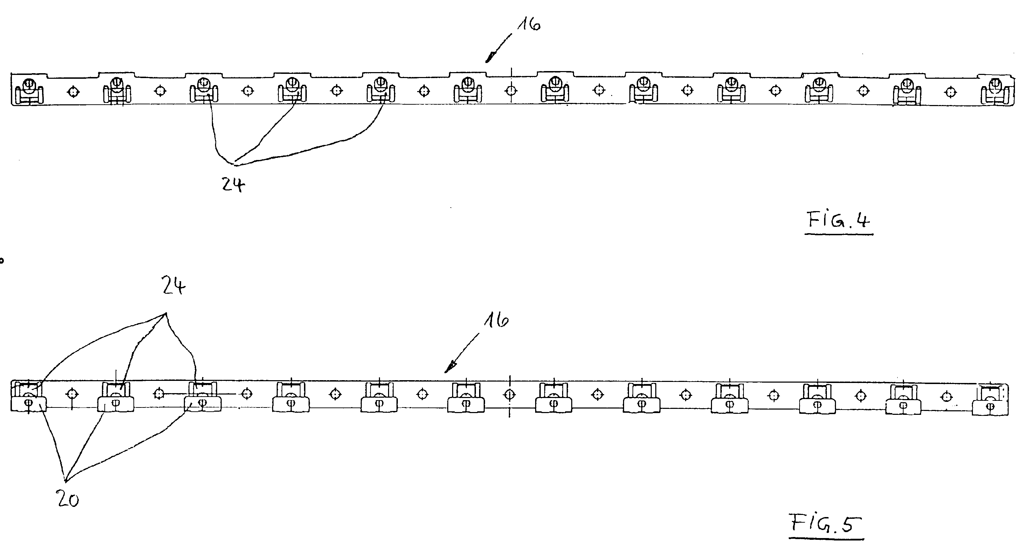

Die Kontaktleiste weist eine Reihe von aus der Kontaktleistenwand freigestanzten und aus der Kontaktleistenebene ausgebogenen Kontaktzungen 24 auf. Wie insbesondere Fig. 2 zeigt, legen sich diese Kontaktzungen 24 jeweils an Kontaktflächen 26 eines benachbarten Wandelementes an. Wie insbesondere Fig. 3 zeigt, haben die Kontaktzungen 24 im Längsschnitt etwa die Form eines stumpfwinkligen Hakens mit einem ersten, aus der Kontaktleistenebene herausgebogenen Schenkel 28 und einem daran anschließenden, zur Kontaktleistenebene zurückgebogenen Schenkel 30. Die Biegekante 32 zwischen dem ersten Schenkel 28 und dem zweiten Schenkel 30 bildet eine linienförmige Kontaktzone.

Die Kontaktzungen 24 sind jeweils mit einer Aussparung 34 versehen, die den Materialquerschnitt im Bereich der Ausbiegekante 36 des ersten Schenkels 28 und damit die Federkraft der Kontaktzunge verringert.

Der den Klammerelementen 20 abgewandte Längsrand 38 der Kontaktleiste ist zur Seite der Klammerelemente 20, d.h. also zur Außenseite 18 des Randsteges 14 hin abgekantet, so daß sich die Kontaktleiste beim Montieren des Wandelementes 2 nicht an der Kontaktfläche 26 des benachbarten Wandelementes 6 verhaken kann.

Die Klammerelemente 20 sind jeweils mit Rastausnehmungen 40 versehen; diese sind dazu bestimmt, sich beim Aufklemmen des Kontaktstreifens auf den Randsteg 14 an diesem ausgebildeten Rastvorsprüngen 42 zu verrasten, wie insbesondere Fig. 3 erkennen läßt.

Fig. 4 zeigt eine Ansicht einer Kontaktleiste in Richtung des Pfeiles 44 in Fig. 1, d.h. also auf die Vorderseite der Kontaktleiste 16. Es ist zu erkennen, daß eine Vielzahl von in regelmäßigen Abständen zueinander angeordneten Kontaktzungen vorgesehen ist. Der Abstand der Kontaktzungen wird aus den Eigenschaften der abzuschirmenden Störstrahlung bestimmt. Er liegt beispielsweise zwischen 2 und 4 cm.

Fig. 5 zeigt eine Kontaktleiste gemäß Fig. 4 in einer Ansicht entsprechend dem Pfeil 46 in Fig. 1 und läßt erkennen, daß eine Vielzahl von Klammerelementen 20 in regelmäßigen Abständen zueinander an der Kontaktleiste 16 angeordnet ist. Wie weiter aus einem Vergleich zwischen den Fig. 4 und 5 zu erkennen ist, sind die Klammerelemente 20 jeweils im Bereich von Kontaktzungen 24 und damit in gleichen gegenseitigen Abständen angeordnet, so daß die Kontaktzungen und die Klammerelemente jeweils gleichzeitig durch ein entsprechend ausgebildeten Stanz-Biegewerkzeug hergestellt werden können.

Die Kontaktleiste 16 ist aus einem federnden, metallischen Material hergestellt.

Wie Fig. 2 erkennen läßt, eignen sich die Kontaktleisten gemäß der Erfindung auch zur Herstellung eines abschirmenden Kontaktes der Gerätewand 50 zum an dieser anliegenden Wandelement 2. Die Klammerelemente 54 durchgreifen geeignete Durchbrüche 56 und übergreifen eine Begrenzungskante der Durchbrüche 56, wobei die eigentliche Kontaktleiste auf der dem Wandelement 2 zugewandten Seite der Gerätewand 50 aufliegt und die Kontaktzungen 58 der Kontaktleiste an der Kontaktfläche 26 des Wandelementes 2 anliegen.

Ebenso kann über eine Kontaktleiste gemäß der Erfindung ein abschirmender Kontakt zwischen einem Wandelement, beispielsweise dem Wandelement 6, und einer in Fig. 2 links davon angeordneten Gerätewand hergestellt werden, wie ohne weiteres verständlich und deshalb nicht näher dargestellt ist.

## Patentansprüche

1. Kontaktleiste (16) aus metallischen Material zum Aufstecken auf die Kante eines metallischen Wandelementes (2) um eine Störstrahlungsdichte Verbindung zu erreichen, wobei eine Längskante der Kontaktleiste klammerartig ausgebildet ist und die Kontaktleiste aus der Leistenebene ausgebogene Kontaktbereiche aufweist, dadurch **gekennzeichnet**, daß die Kontaktleiste (16) eine Reihe von einzelnen aus der Kontaktleistenebene freigestanzten und ausgebogenen, zueinander beabstandeten Kontaktzungen (24) und eine Reihe von einzelnen über ihre Länge verteilten zueinander beabstandeten Klammerelementen (20) aufweist.

2. Kontaktleiste nach Anspruch 1, dadurch **gekennzeichnet,** daß die Klammerelemente (20) jeweils mit einer Rastausnehmung (40) zum Verrasten mit einem am Randsteg (14) des Wandelementes (2) ausgebildeten Rastvorsprung (42) versehen sind.

3. Kontaktleiste nach Anspruch 1 oder 2, dadurch **gekennzeichnet**, daß die Kontaktzungen (24) im Längsschnitt die Form eines stumpfwinkligen Hakens mit einem ersten, aus der Kontaktleistenebene herausgebogenen Schenkel (28) und einem daran anschließenden, in Richtung zur Kontaktleistenebene zurückgebogenen Schenkel (30) haben.

4. Kontaktleiste nach einem der Ansprüche 1 bis 3, dadurch **gekennzeichnet**, daß der den Klammerelementen (20) abgewandte Längsrand (38) der Kontaktleiste zur Seite der Klammerelemente (20) hin abgekantet ist.

5. Kontaktleiste nach einem der Ansprüche 1 bis 4, dadurch **gekennzeichnet**, daß die Kontaktzungen (24) jeweils mit einer den Materialquerschnitt im Bereich der Ausbiegekante (36) des ersten Schenkels (28) verringernden Aussparung (34) versehen sind.

6. Kontaktleiste nach einem der Ansprüche 1 bis 5, dadurch **gekennzeichnet**, daß die Kontaktzungen (24) einen gegenseitigen Abstand von zwischen 2 cm und 4 cm haben.

7. Kontaktleiste nach einem der Ansprüche 1 bis 6, dadurch **gekennzeichnet**, daß die Klammerelemente (20) einen gegenseitigen Abstand von zwischen 2cm und 4 cm haben.

8. Kontaktleiste nach einem der Ansprüche 1 bis 7, dadurch **gekennzeichnet**, daß jeder Kontaktzunge (24) jeweils ein im gleichen Längsbereich der Kontaktleiste (16) angeordnetes Klammerelement (20) zugeordnet ist.

## Claims

1. Contact strip (16), composed of metallic material, for plugging onto the edge of a metallic wall element (2) in order to achieve a connection which is proof against interference radiation, a longitudinal edge of the contact strip being constructed like a bracket, and the contract strip having contact regions bent out of the strip plane, characterized in that the contact strip (16) has a row of individual contact tongues (24) which are stamped and bent out of the contact strip plane and are at a distance from one another, and a row of individual bracket elements (20), which are distributed over its length and are at a distance from one another.

2. Contact strip according to Claim 1, characterized in that the bracket elements (20) are in each case provided with a latching recess (40) for latching to a latching projection (42) which is constructed on the edge web (14) of the wall element (2).

3. Contact strip according to Claim 1 or 2, characterized in that the contact tongues (24) have, in longitudinal section, the shape of an obtuse-angled hook with a first limb (28), which is bent out of the contact strip plane, and a limb (30), which is adjacent thereto and is bent back in the direction of the contact strip plane.

4. Contact strip according to one of Claims 1 to 3, characterized in that that longitudinal edge (38) of the contact strip which faces away from the bracket elements (20) is angled towards the side of the bracket elements (20).

5. Contact strip according to one of Claims 1 to 4, characterized in that the contact tongues (24) are in each case provided with a cutout (34) which reduces the material cross-section in the region of the bent-out edge (36) of the first limb (28).

6. Contact strip according to one of Claims 1 to 5, characterized in that the contact tongues (24) are separated from one another by distance of between 2 cm and 4 cm.

7. Contact strip according to one of Claims 1 to 6, characterized in that the bracket elements (20) are separated from one another by a distance of between 2 cm and 4 cm.

8. Contact strip according to one of Claims 1 to 7, characterized in that each contact tongue (24) in each case has allocated to it a bracket element (20) which is arranged in the same longitudinal region of the contact strip (16).

## Revendications

1. Réglette de contact (16), en un matériau métallique, destinée à être enfichée sur le bord d'un élément de paroi (2) métallique pour obtenir une liaison imperméable à un rayonnement parasite, un bord longitudinal de la réglette de contact étant en forme de pince et la réglette de contact comportant des zones de contact coudées hors du plan de la réglette, caractérisée par le fait que la réglette de contact (16) comporte une série de languettes (24) de contact, à distance les unes des autres, qui sont découpées dans le plan de la réglette de contact et coudées, et une série d'éléments (20) en forme de pinces, à distance les uns des autres, qui sont répartis sur toute sa longueur.

2. Réglette de contact suivant la revendication 1, caractérisée par le fait que les éléments en forme de pinces (20) comportent chacun un évidement d'encliquetage (40) pour l'encliquetage d'une saillie d'encliquetage (42) formée sur le bord (14) en forme de réglette de l'élément de paroi (2).

3. Réglette de contact suivant la revendication 1 ou 2, caractérisée par le fait que les languettes de contact (24) ont, en coupe longitudinale, la forme d'un crochet à angle obtus ayant une première branche (28) coudée hors du plan de la réglette de contact, et une branche (30) se raccordant à la précédente et coudée en direction du plan de la réglette de contact.

4. Réglette de contact suivant l'une des revendications 1 à 3, caractérisée par le fait que le bord longitudinal (38), tourné à l'opposé des éléments (20) en forme de pinces, de la réglette de contact est coudé du côté des éléments (20) en forme de pinces.

5. Réglette de contact suivant l'une des revendications 1 à 4, caractérisée par le fait que les languettes de contact (24) comportent chacune un évidement (34), qui réduit la section transversale de matière dans la zone de l'arête de coudage (36) de la première branche (28).

6. Réglette de contact suivant l'une des revendications 1 à 5, caractérisée par le fait que les languettes de contact (24) sont à une distance mutuelle comprise entre 2 cm et 4 cm.

7. Réglette de contact suivant l'une des revendications 1 à 6, caractérisée par le fait que les éléments (20) en forme de pinces sont à une distance mutuelle comprise entre 2 cm et 4 cm.

8. Réglette de contact suivant l'une des revendications 1 à 7, caractérisée par le fait qu'à chaque languette de contact (24) est associé respectivement un élément (20) en forme de pince, qui est disposé dans la même partie longitudinale de la réglette de contact (16).
